# EUROPEAN PATENT APPLICATION

(11) **EP 3 647 459 A1**
(43) Date of publication of application: **06.05.2020**
(21) Application number: 18203800.0
(22) Date of filing: 31.10.2018
(51) Int. Cl.: C23C 16/04, C04B 35/83

(54) **METHOD AND AN ASSEMBLY BY CHEMICAL VAPOR INFILTRATION OF POROUS COMPONENTS**

(71) Applicant: Petroceramics S.p.A., 24040 Stezzano, Bergamo (IT)
(72) Inventor: VAVASSORI, Paolo, I-24040 Stezzano, BERGAMO (IT); VALLE, Massimiliano, I-24040 Stezzano, BERGAMO (IT)
(74) Representative: Crippa, Paolo Ernesto

(57) **Abstract**

The present invention relates to a CVI (chemical vapor infiltration) method for densifying at least one porous component (1), comprising at least the steps of:
- placing the at least one porous component (1) inside a crucible (3);
- bringing the temperature (Ti) inside the crucible (3) to a suitable value for the densification of the porous component (1) to transform it into a densified component (2);
- bringing the pressure (Pi) inside the crucible (3) between 0.1 kPa and 25 kPa;
- upon reaching steady state temperature and pressure, flushing a reaction gas (4) inside the crucible;
- said reaction gas, or gas (4) is fed inside the crucible (3), said gas (4) being suitable for the densification of the porous component (1) to transform it into a densified component (2);
comprising the additional steps of
- maintaining an oxidizing environment external to the crucible (3), wherein said external environment laps upon said crucible (3);
and wherein
- said crucible (3) is provided in a material that allows a thermal conductivity above 30 W/mk from ambient temperature to at least 1000°C.

## Description

### . Field of the invention

The present invention relates to a method and an assembly for chemical vapor infiltration of porous components that are densified, for example when placed in stacks in a reactor.

In particular, the present invention relates to devices, or assemblies, for chemical vapor infiltration and rapid densification of preforms, for example ceramic preforms. In these plants, inside a reactor, or crucible, in appropriate conditions of flow, of partial pressure and of temperature, the decomposition is obtained of a gaseous precursor, for example methane or methylchlorosilane, into its components, for example carbon and silicon carbide, which are deposited inside the porous preform composed of the same materials or compatible materials in the form of fibers, fabrics or other. Reference shall hereafter be made to the densification of carbon/carbon (C/C) preforms, but the same concepts can be extended to other types of materials.

For example, these porous components are substantially symmetrical circularly or annular with a central passage or opening, and they are placed in at least one stack, or pile, which defines an inner passage formed by the central openings of the components.

Still further, the field of the invention resides in the fabrication of components that consist of a composite material comprising a porous substrate, or "preform", densified in its matrix, in particular in the production of brake disks made of composite material by means of the densification of preforms made of fibers, for example arranged in annular shape.

### . State of the art

The fabrication of parts made of composite material, in particular parts made of composite material consisting of a fiber preform, for example carbon fibers or ceramic fibers, is obtained by densifying the matrix of the preform for example with chemical vapor infiltration methods.

Examples of such components are carbon-carbon (C-C) composite brake disks, in particular for brakes of sports cars or for aeronautical brakes. Densifying porous components by chemical vapor infiltration consists of placing the components in a reaction chamber, or crucible, of an infiltration system and of injecting a gas into the chamber in which one or more components of the gas form a precursor for the material of the matrix of the component to be deposited inside the component for the purpose of densifying it.

The infiltration conditions, in particular the concentration, the gas flow rate, the temperature and the pressure inside the chamber of the crucible, are selected to allow the gas to diffuse inside the accessible inner pores of the components so that the desired material is deposited therein by deposition on the fibers or generically on the material of the component.

The conditions required for the chemical vapor infiltration of pyrolytic carbon, or "pyrocarbon" have long been known to the person skilled in the art. The precursor of carbon is an alkane, an alkyl or an alkene, generally propane, methane or a mix of both. The infiltration is carried out at a temperature of approximately 1000°C at a pressure from approximately 1 kPa (10 mmBar) to approximately 15 kPa (150 mmBar), hence in fact in an environment defined as a vacuum, albeit not a high one.

One of the reasons, though not the main one, of the need for vacuum, of a vacuum environment, at least as defined above, resides in the simultaneous presence in this process of a flammable gas and of high temperatures in the furnace surrounding the reaction environment, conditions that could lead, in case of accidental contact with oxygen, to a deflagration of the environment and hence of the crucible and of the entire system.

Also known are the conditions required for chemical vapor infiltration of materials other than carbon, in particular of ceramic materials. Reference can be made in particular to the document FR-A-2 401 888 and to the document CA 02268729. In an industrial installation for chemical vapor infiltration, it is common practice to load the reaction chamber of the crucible with a plurality of substrates or preforms or components to be densified simultaneously, with the use of support tools or spacers positioned among the components. When the preforms are annular, they can be placed in stacks in longitudinal direction to the reaction chamber.

The substrates are brought to the desired temperature by means of heating produced by a susceptor, or inductor, which generally consists of graphite placed in a graphite chamber that defines the inner volume of the chamber of the furnace, forming a secondary induction circuit that is electromagnetically coupled with a primary induction circuit situated outside the chamber of the furnace. The gas containing the precursor of the material to be deposited inside the preform is introduced in a longitudinal end of the chamber while the residual gas is evacuated from the opposite end where it is extracted by pump means or vacuum pumps. The gas is generally pre-heated before reaching the preforms that have to be densified, for example passing through perforated pre-heat plates. The entire chamber of the furnace is enclosed in a container, or vessel, so as to condition the environment that surrounds the susceptor and the walls of the furnace and above all the walls of the crucible contained therein. An imperative objective is to reduce pressure, thereby reducing the presence of oxygen in the furnace.

The graphite, or the like, is among the best suited material for arranging the entire setup inside the vessel because it is able to withstand high process temperatures, because it is a material with electrical properties, able to constitute resistors and susceptors, and because of its high thermal conductivity. The consequence of the use of this material is the need to protect these components against oxidation. Hence, oxygen is doubly dangerous, first of all because of the simultaneous presence of both a flammable gas such as methane and of high temperatures, and also because in an environment with oxygen the components made, for example, of graphite, deteriorate by oxidation. The need to have non-oxidizing environments and the removal of oxygen from the densifying gas, has driven all prior art solutions, when a considerable work volume is present, i.e. one suitable for an industrial process (hence not for laboratories and testing of very small quantities) of a protective structure or chamber around the crucible, hence a second chamber around the chamber formed by the crucible, that is sealed and also able to be emptied of oxygen, for example by the creation of vacuum also outside the crucible, if not also the insufflation of inert gases such as nitrogen. These needs make known systems highly complex and extremely costly.

More in particular, chemical vapor infiltration is a process that requires a great deal of time. To meet the requirements for industrial scale production, it is necessary to be able to density the highest possible number of substrates, or preforms or components, simultaneously, ensuring, however, that all substrates are densified in the same way.

In particular, it is necessary for all substrates to reach the same degree of densification with a matrix with the same microstructure. For this purpose, the document WO-A-96/33295 proposes to position annular preforms in one or more stacks that extends in the longitudinal direction of the reaction chamber, each stack defining a longitudinal inner passage. A similar solution is known from US-A-5 580 678**.**

Other similar solutions are known from US2015152547**,** US2016305015**,** US2007054103**,** US5024878**,** US2014272373**,** US2016229758**,** US6068930**,** WO9616000**,** EP2058841**,** US2014356534**,** CN103744302**,** EP0499004**,** US5916633**,** US6197374**,** US2012231157**,** CN203561850**,** US6410086**,** US5332597**,** US5480678**,** KR101494237**,** US2008143005**,** US6187379**,** US2004115348**,** US2016229758**,** US2016305015**,** US2015152547**,** US2005238564**,** US5389400**,** CN104387113**,** CN103288466**,** US2015152545**,** US2013302616**,** US4824711**,** US2010296621**,** US 5238710 A**,** US 8163088 B2**,** US 6083560 A**,** US 5254374 A**,** US 8105649 B1**,** US 6197374 B1**,** US 5738908**,** US 8491963 B2**,** US 3925577 A**.**

However, these known solutions, as well as other known solutions for densifying carbon preforms, have some limitations. Some of these limitations derive from the technologies and from the materials employed for the manufacture of the devices or equipment.

In the process for the rapid densification of carbon by decomposition of gas, in particular of methane, the process temperature is around 1000 - 1150°C. There are few metal alloys with which to construct the process chamber that can work at these temperatures. Moreover, the atmosphere to which the chamber is exposed is strongly reducing because of the hydrogen produced by the methane decomposition reaction in the formation of the pyrolytic carbon that is deposited on the component to be densified. The reactor is closed in a second sealed container that works under vacuum or inert gas. Moreover, these materials (for example, Kanthal®) at high temperature exhibit a severe reduction of the mechanical characteristics and are subject to degradation phenomena (for example, creep). This entails dimensioning the walls of the reactor with very significant thicknesses (typically some tens of millimeters) with consequent higher costs in addition to the limited useful life of the component. Moreover, safety questions also arise because an accidental overtemperature by a few tens of degrees with respect to the operating limit can cause the collapse of the structure.

For this set of reasons, reactors, in particular Rapid-CVI reactors that use methane, are constructed with a graphite reaction chamber that can operate without any problems at the required temperatures and in reducing atmosphere.

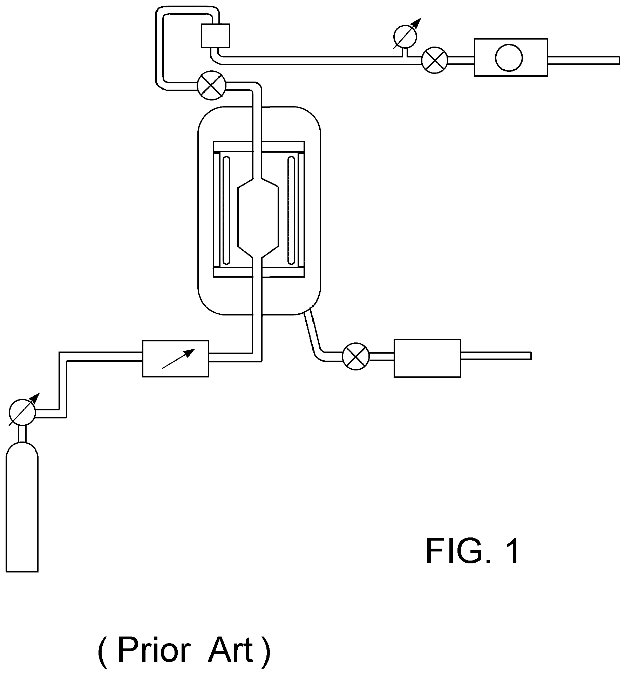

Obviously, this chamber must be closed inside a second gas-tight vessel, usually made of stainless steel, appropriately insulated with carbon refractories and water-cooled, with consequent costs and complexity of the system. The resistors or inductors for heating the reactor are also made of graphite (see Figure 1).

Moreover, the graphite reaction chamber is not able to guarantee tightness against the reaction gases, whose escape into the outer vessel entails that the reaction chamber is deposited in thick and compact layers on the outer part of the chamber itself. In addition, the carbon is deposited in general on all the inner walls of the reactor, on the thermal insulators that progressively degrade, on the graphite bars of the resistor that have to be cleaned, and inside the recesses present in the support that tend to become obstructed.

Although the temperatures at play, the quantity of heat necessary to the entire process and the precision in the control and in the uniformity of heating can be managed with a conventional gas heating system, with significant savings on the cost of energy, such a solution cannot be implemented because all the materials used are graphite-based and hence cannot be exposed to flame in air.

An additional aspect that is not solved by prior art solutions involves the pumping set that allows to maintain the chamber of the reactor in a vacuum, which in current systems is provided by a liquid ring pump. The choice of this type of pump is dictated by several requirements. First of all, this choice allows to ensure operation in the presence of a gas contaminated with aromatic compounds that condense forming tar that is deposited inside the pipes and the pump. Moreover, contact between the mix of methane and hydrogen and flammable substances has to be avoided. In addition, it is necessary to meet the vacuum and flow rate specifications. By contrast, this solution also has a series of important disadvantages. The entire pumping set is very costly; by itself it can account for nearly 40% of the cost of the entire system. In addition, it requires frequent cleanings (approximately every 400 hours) and long plant shutdowns. It also requires the disposal of large volumes of contaminated water.

Therefore, it is still necessary to have a high productive efficiency, with the contrasting and simultaneous need to simplify the construction of the production assemblies, while maintaining a high production quality.

These needs led the applicant to search for new plant solutions.

### . Solution

These and other needs and objectives are achieved with a chemical vapor infiltration according to claim **1** and an assembly for densifying porous components according to claim **11.**

Some advantageous embodiments are set forth in the dependent claims.

The present invention has allowed to have an oxidizing environment external to the crucible that leads to far less complex and costly systems, which allow the use of a type of furnace that is far simpler to build and operate and less expensive to maintain; for example furnaces for oxides.

In addition, according to an additional embodiment, by virtue of the proposed solution, a considerable simplification in the system is obtained, for example reducing the vacuum system, eliminating the gaskets needed to maintain the proper seals, changing the materials of the components and of the crucible itself with more advantageous materials.

For example, if a carbide crucible is used, it is possible to replace the graphite of the chamber of the furnace and of the resistors with other materials that can operate at high temperatures even in the presence of air (oxidizing environment), allowing to drop two constructive constraints: maintaining vacuum outside the crucible and the heating method by means of graphite resistors.

For example, in a proposed solution a crucible made of ceramic material is used, specifically one made of silicon-infiltrated silicon carbide. This material has a series of positive characteristics:
- it withstands temperatures up to 1400°C with degradation of the mechanical characteristics;
- at these temperatures it can be exposed to both oxidizing and reducing atmosphere without being attacked chemically;
- it does not react with carbon and hence pyrolytic carbon is not deposited or is deposited without adhesion on its surface and it can be easily removed, simplifying maintenance operations;
- this crucible has high thermal conductivity (between 100 and 200 W/m K at 20°C and above 30 W/m up to 1000°C). By comparison, the thermal conductivity of steels is of the order of 10-30 W/m K at 20°C that declines as temperature increases; *inter alia,* steels have the problem that their mechanical properties deteriorate as temperatures rise. Therefore, this material transmits heat efficiently through the walls of the crucible, reducing the energy transients necessary to attain the desired temperature and the gradients within the reaction chamber.

Furthermore, this material has low density (3 kg/dm3) and hence does not need large, bulky and expensive support structures.

Moreover, it is possible to produce reactors with volumes of at least 0.5 m3, to accommodate products to be densified of medium and large size as well.

In addition, by virtue of the proposed solutions it no longer necessary to maintain a vacuum externally to the crucible and hence it is no longer necessary to make the container external to the crucible of the furnace of steel or similar materials and to provide a vacuum seal. Otherwise, a simple insulated carpentry structure can be used, allowing to dramatically reduce the construction complexity and costs.

For example, the refractory materials, currently built with costly graphite foam can be replaced with more conventional and economical oxide-based refractories.

Heating, for example electrical heating, can be carried out replacing graphite resistors with conventional Kantal® resistors, simpler and easier to drive electrically, with further system simplification thanks to the elimination of the transformer.

Moreover, according to additional embodiments, it is possible to eliminate electric heating with resistors and replace it with a gas burner system. This solution appears particularly advantageous, because it allows to reuse a portion of the exhaust gases of the reactor. Carbon deposition yields are low and hence upon unloading the furnace there is a gas mixture that still contains approximately 65% of methane and 30% of hydrogen, which in the solutions preceding the present invention is released directly into the atmosphere or burned in afterburners as it flows out of the plant. In both cases there is an impact on the environment and waste of potentially reusable gas. By using the exhaust gas from the crucible to heat the furnace, a dual economic and environmental advantage is obtained.

In case of use of a crucible made of carbides, for example silicon carbides, since the reactor can be exposed to air without being damaged, considering that silicon carbide withstands high thermal shocks, once the high temperature densification phase is completed the furnace can be opened to extract the crucible without waiting for the long cooling phase. The materials of the resistors and of the refractories do not degrade as a result of exposure to air at high temperature. Therefore, it is possible to build a plant in which the closed reactor under vacuum is removed while still hot and replaced with another reactor loaded with a new batch of preforms to be densified. In this way, cooling and heating times are considerably reduced (the furnace is, and remains hot), with consequent increase in productivity and saving of the energy necessary for the heating transient.

If a carbide, for example silicon carbide, crucible, or ceramic reactor, is used, an advantageous technological aspect is that of allowing the use of a different technology for the vacuum seals between the parts of the reactor (chamber and lid) and between them and the external pipes. The parts that constitute the reactor must operate at temperatures above 1000°C. Substantially, there are no materials that can be used as gaskets to provide a seal at these temperatures. However, the vacuum levels that have to be ensured inside the crucible are not high; therefore, it is sufficient that losses are lower than 0.2 mbar/min at 150 mbar of partial pressure. In accordance with one embodiment, the adopted solution is not to insert any gasket but to place directly in contact the ceramic surfaces of the crucible that were previously ground and possibly lapped until obtaining a sufficiently low value of roughness to ensure the gas-tight contact between them. The pressure exerted between the different parts of the crucible because of their own weight and of the application of the vacuum inside the chamber of the crucible itself, is sufficient to ensure gas tightness throughout the range of operating conditions of the reactor. The external connections of the chamber (reaction gas inlet and outlet) were found to be at temperatures below 150°C in all operating conditions and hence for these junctions it is possible to use conventional high temperature gaskets (for example made of graphite).

In accordance with one embodiment, for the intake line of the reaction gases containing heavy hydrocarbons, a condensation system is inserted along the connecting line between the reactor and the pump, to cool the gas and cause the tar to condensate. It is not necessary to achieve a nearly complete elimination, such as would fall within the limits of environmental emissions; it is sufficient to have enough tar reduction to allow use of a conventional dry pump to form the vacuum.

The connecting pipes are jacketed and water-cooled. Their length is dimensioned so as to obtain a cooling of the gas to 60°C before entry into the pump. The different segments of the line are inclined and the tar that condenses is collected in a series of pits that can be opened for cleaning. This solution makes cleaning operations quick and infrequent, since the condensed tar is all collected without any dilution liquid to be disposed of. In addition to the advantages relating to maintenance, it is necessary to consider the reduction of the installation costs that does not regard only the elimination of the water tank and the connected components but also the elimination of the heat exchanger and of the refrigeration set which are currently necessary for the liquid ring pump which requires water at a constant temperature from 15° to 18°C to operate correctly. Thanks to the proposed solution, it is possible to use water coming from a cooling tower from 25 to 30°C.

### . Figures

Further features and the advantages of the invention shall become readily apparent from the following description of preferred embodiments thereof, provided by way of non-limiting indication, with reference to the accompanying figures, in which:
- Figure 1 shows a diagram of a CVI system according to the state of the art;

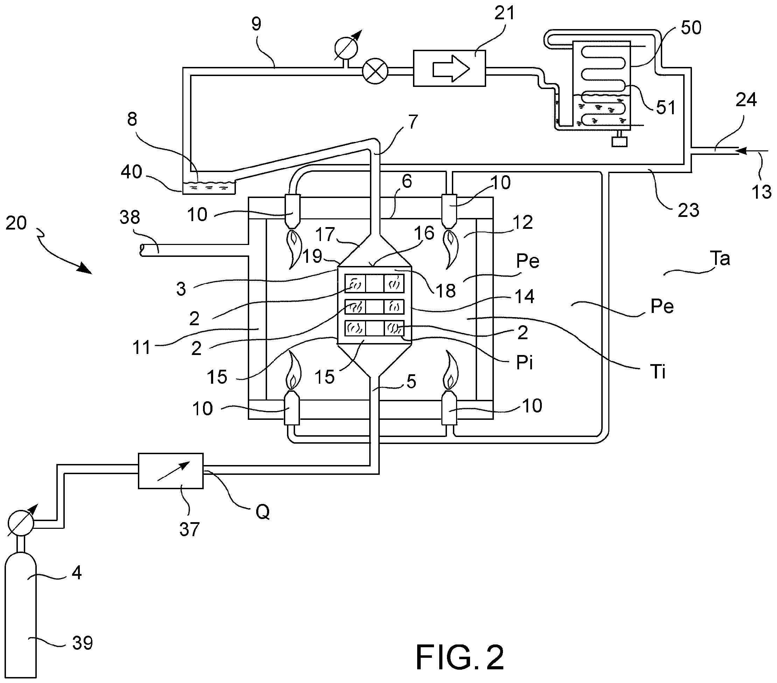

- Figure 2 shows a diagram of a chemical vapor infiltration system according to a first embodiment, in which the furnace uses burner devices;

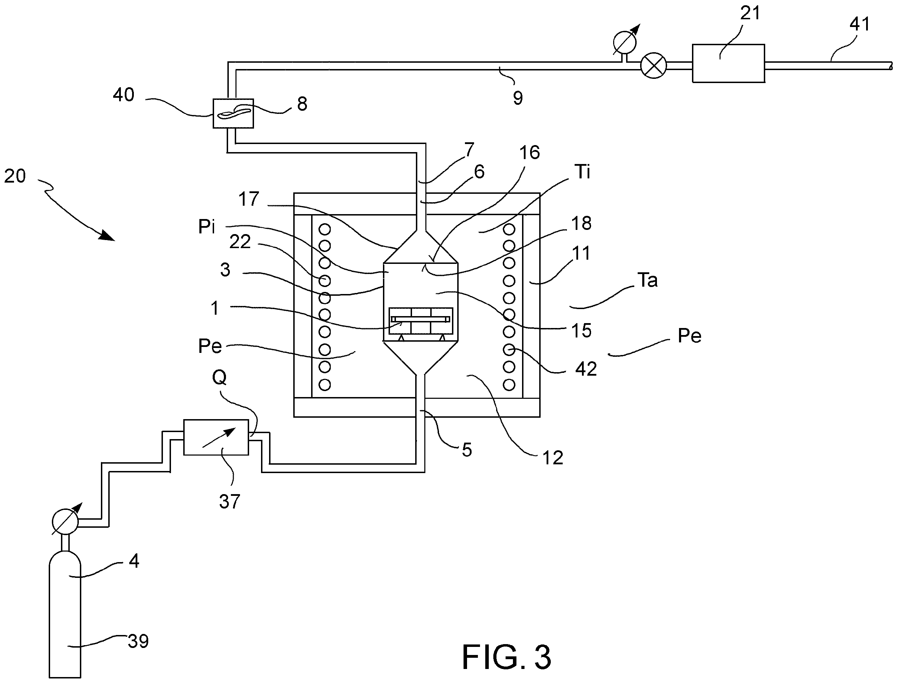

- Figure 3 shows a second diagram of a chemical vapor infiltration system according to a second embodiment, in which the furnace uses electrical resistance or induction devices;

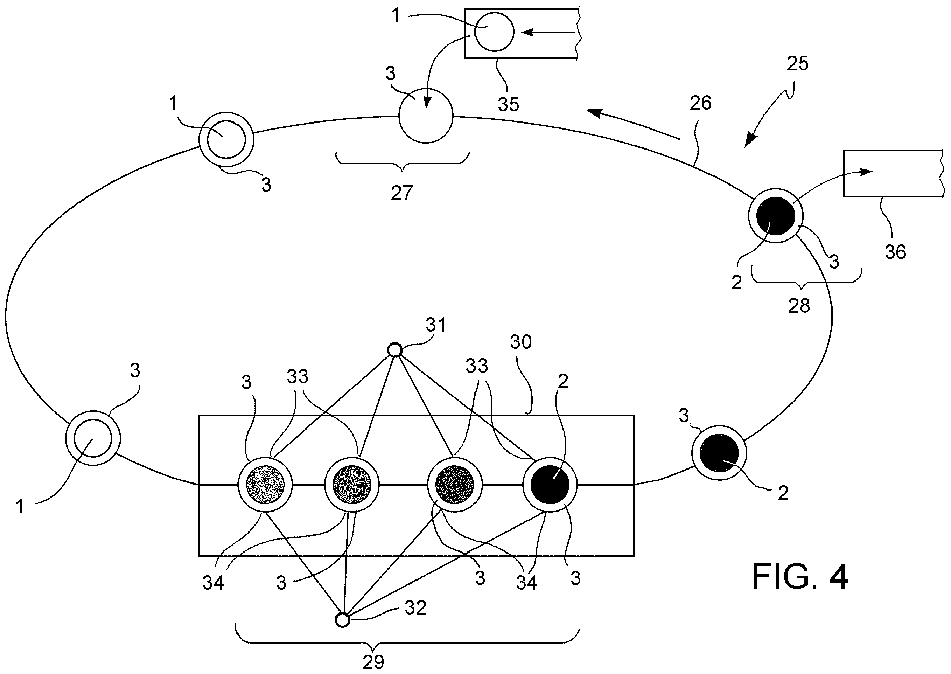

- Figure 4 shows a third diagram of a chemical vapor infiltration system according to a third embodiment, in which the furnace is of the tunnel type and a circuit or carrousel is provided for moving a plurality of crucibles that transit in different stations for loading, processing in the furnace and unloading the components;

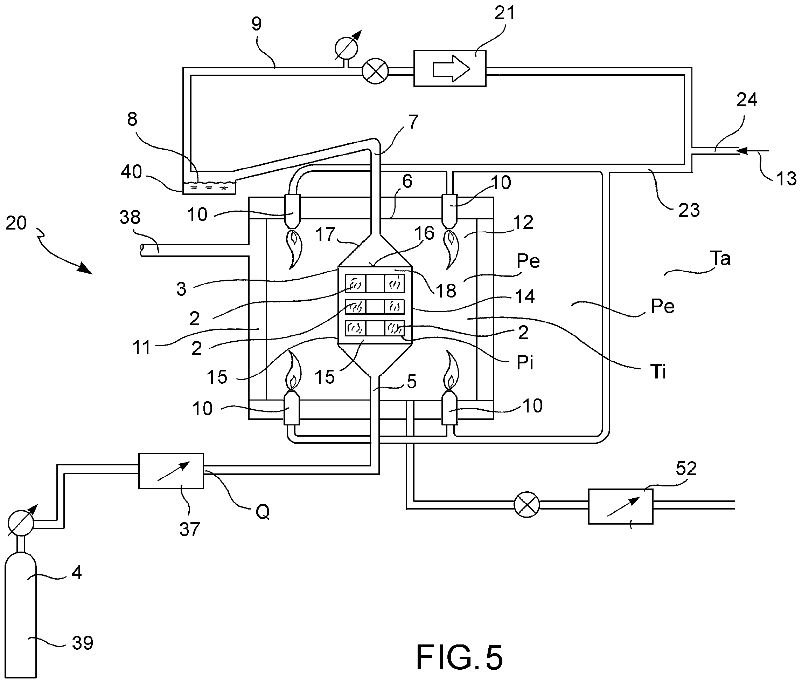

- Figure 5 shows a fourth diagram of a chemical vapor infiltration system according to a fourth embodiment, in which a gas tight container, external to the crucible, is provided to bring the pressure in a chamber external and adjacent to the crucible below the ambient pressure;

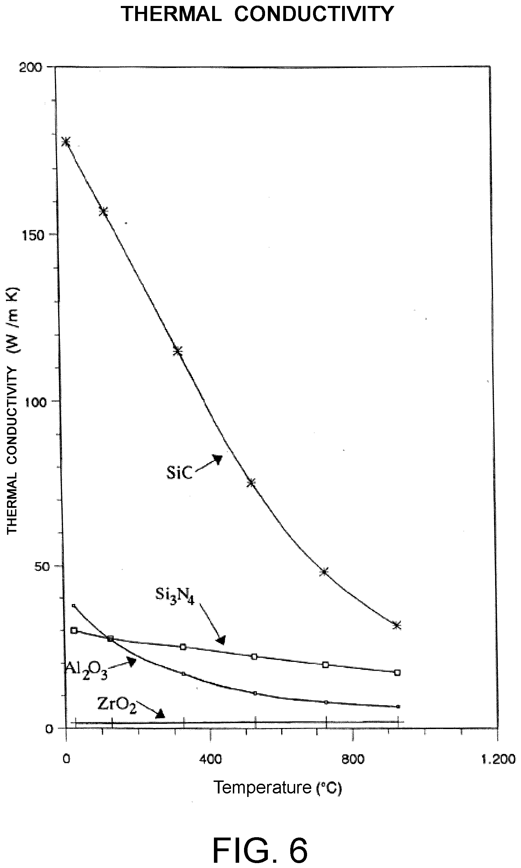

- Figure 6 graphically represents thermal conductivity as temperature changes, for different materials in comparison with SiC.

### . Description of some preferred embodiments

The term "reducing atmosphere" or "reducing" means, for example, a reducing atmosphere because of the hydrogen produced by the methane decomposition reaction in the formation of the pyrolytic carbon that is deposited on the component to be densified.

In accordance with a general embodiment, a CVI, or chemical vapor infiltration, method for densifying at least one porous component 1 is provided, comprising at least the steps of:
- placing the at least one porous component 1 inside a crucible 3;
- bringing the temperature and pressure Ti, Pi inside the crucible 3 to a suitable value for the densification of the porous component 1 to transform it into a densified component 2;
- upon reaching steady state temperature and pressure, flushing a reaction gas (4) inside the crucible;
- said reaction gas, or gas (4) is fed inside the crucible 3, said gas 4 being suitable for the densification of the porous component 1 to transform it into a densified component 2;
   comprising the additional steps of
- maintaining an oxidizing environment external to the crucible 3, wherein said external environment laps upon said crucible 3;
   and wherein
- said crucible 3 is provided in an environment that allows thermal conductivity above 30 W/mK from ambient temperature to 1000° C.

By virtue of this solution, the chamber of the crucible is heated effectively and rapidly.

In accordance with an additional embodiment of the method, the additional step is provided of bringing the pressure Pi inside the crucible 2 between 0.1 kPa and 25 kPa.

In accordance with an additional embodiment independent from the previous one, a CVI, or chemical vapor infiltration, method for densifying at least one porous component 1 is provided, comprising at least the steps of:
- providing a graphite crucible 3;
- placing the at least one porous component 1 inside said crucible 3;
- bringing the temperature and pressure Ti, Pi inside the crucible 3 to a suitable value for the densification of the porous component 1 to transform it into a densified component 2;
- feeding gas 4 into the crucible 3, said gas 4 being suitable for the densification of the porous component 1 to transform it into a densified component 2;
   comprising the additional steps of
- at steady state temperature and pressure, flushing a reaction gas (4) inside the crucible 3;
   and wherein
- the pressure Pe external to the crucible 3 is maintained at ambient pressure.

In accordance with an additional embodiment of the method, the additional step is provided of jacketing and/or coating said graphite crucible with an oxidation-resistant material.

In accordance with an additional embodiment of the method, the additional step is provided of bringing the pressure Pi inside the crucible 2 between 0.1 kPa and 25 kPa.

In accordance with an additional embodiment of the method, the additional step is provided of jacketing said crucible with an oxidation-resistant material.

In accordance with an additional embodiment of the method, the additional step is provided wherein said coating is made of material comprising engobbio ®, or engobe.

In accordance with an additional embodiment of the method, the additional step is provided wherein said coating is made of material comprising metals, for example refractory steels.

In accordance with an additional embodiment of the method, the additional step is provided of obtaining a reducing environment inside the crucible (3) at steady state temperature and pressure and gas flushing.

In accordance with an additional embodiment of the method, the additional step is provided of providing as the porous component 1 a component with matrix comprising fibers.

In accordance with an additional embodiment of the method, the additional step is provided of providing as the porous component 1 a component with matrix comprising carbon fibers.

In accordance with an additional embodiment of the method, the additional step is provided of providing as the porous component 1 a component with matrix comprising carbon fibers and pyrolytic carbon.

In accordance with an additional embodiment of the method, the additional step is provided of providing as the porous component (1) a component with matrix comprising silicon carbide (SiC) fibers.

In accordance with an additional embodiment of the method, the additional step is provided of providing as the porous component (1) a component with matrix comprising silicon carbide (SiC) fibers and pyrolytic carbon.

In accordance with an additional embodiment of the method, the additional step is provided of providing as the porous component (1) a component with matrix comprising silicon carbide (SiC) fibers and silicon carbide.

In accordance with an additional embodiment of the method, the additional step is provided of bringing the temperature Ti inside the crucible 3 between 900°C and 1300°C, preferably from 1050 to 1200°C.

In accordance with an additional embodiment of the method, the additional step is provided of: upon reaching steady state temperature suitable for densification, obtaining a non-oxidizing environment inside the crucible (3); and wherein during the entire process, an oxidizing environment is maintained outside the crucible (3), wherein said external environment laps said crucible (3).

In accordance with an additional embodiment of the method, the additional step is provided of: upon reaching temperature steady state suitable for densification, obtaining a reducing environment inside the crucible 3; and wherein, during the entire process, an oxidizing environment is maintained outside the crucible 3, wherein said external environment laps said crucible 3.

In accordance with an additional embodiment of the method, the additional step is provided of providing said crucible 3 from a material that allows a thermal conductivity between 120 and 80 W/mK at 400°C.

In accordance with an additional embodiment of the method, the additional step is provided of maintaining the pressure Pe outside the crucible 3 equal to ambient temperature, approximately 90 Kpa.

In accordance with an additional embodiment of the method, the additional step is provided of obtaining, at steady state temperature and pressure suitable for densification, a reducing environment inside the crucible 3; and maintaining an oxidizing environment outside the crucible 3, wherein said external environment laps said crucible 3.

In accordance with an additional embodiment of the method, the additional step is provided of regulating the flow of the gas (4) at the inlet (5) of the crucible (3) at a value between 0.1 I/min/dm3 and 10 l/min/dm3.

In accordance with an additional embodiment of the method, the additional step is provided of regulating the flow of the gas 4 at the inlet 5 of the crucible 3 at a value between 1 l/min/dm3 and 5 l/min/dm3.

The flushing of gas 4 can be slower to have a greater deposit of pyrolytic carbon that can be restructured into graphite with post-treatment, allowing a higher conductivity of the material.

If the gas flushing velocity is higher, a carbon deposit that is harder to restructure is obtained, but production times are reduced.

In accordance with an additional embodiment of the method, the additional step is provided of washing the crucible with nitrogen N2 during the start of the process, until the temperature of the crucible reaches a value close to the suitable value for the densification of the porous component 1 to transform it into a densified component 2.

In accordance with an additional embodiment of the method, the additional step is provided of bringing the pressure (Pi) inside the crucible (3) between 1 kPa and 20 kPa.

In accordance with an additional embodiment of the method, the additional step is provided of bringing the pressure Pi inside the crucible 3 between 10 kPa and 15 kPa.

In accordance with an additional embodiment of the method, the additional step is provided wherein said crucible 3 avoids defining a thermal barrier between the environment outside the crucible and the environment inside the crucible.

In accordance with an additional embodiment of the method, the additional step is provided of providing said crucible 3 so that its thermal conductivity is above 30 W/mK at 1000°C.

In accordance with an additional embodiment of the method, the additional step is provided of maintaining the pressure Pe outside the crucible 3 equal to ambient temperature.

In accordance with an additional embodiment of the method, the additional step is provided of regulating the flow of the gas 4 at the inlet 5 of the crucible 3 between 10 I/min and 60 I/min.

In accordance with an additional embodiment of the method, the additional step is provided of bringing the pressure Pe outside the crucible 15 to no less than 15 KPa.

In accordance with an additional embodiment of the method, the additional step is provided of maintaining a pressure difference between the environment inside the crucible 3 and outside the crucible 3, wherein the external environment has an overpressure with respect to the internal environment above 5 Kpa.

In accordance with an additional embodiment of the method, the additional step is provided of maintaining a pressure difference between the environment inside the crucible 3 and outside the crucible 3, wherein the external environment has an overpressure with respect to the internal environment above 10 Kpa.

In accordance with an additional embodiment of the method, the additional step is provided of, at the outlet of the crucible 3, separating the tar and/or cyclic aromatic hydrocarbons from the fumes 7 flowing out of the crucible.

In accordance with one embodiment, the exhaust gas flowing out of the crucible is used for burners that raise or maintain the temperature of the furnace. Thanks to this provision, it is possible to avoid the total separation of the tar and of the cyclic aromatic hydrocarbons because they are burned by the burners such as in a thermal destruction system.

In accordance with an additional embodiment of the method, the additional step is provided of feeding to the crucible 3 as gas suitable for densification 4 methane, or butane, or ethane, or propane, or a combination thereof, and/or preferably methane with purity of 96%.

In accordance with an additional embodiment of the method, the additional step is provided of bringing the exhaust gas 9 flowed out of the crucible 3 to ambient temperature Pe.

In accordance with an additional embodiment of the method, the additional step is provided of accumulating the exhaust gas 9 at ambient temperature in an accumulation tank 50.

In accordance with an additional embodiment of the method, the additional step is provided of using exhaust gas 9 flowed out of the crucible 3 and brought to ambient pressure Pe as fuel for feeding at least one burner 10 to bring and/or maintain the desired temperature Ti of the crucible 3.

In accordance with an additional embodiment of the method, the additional step is provided of using, during the initial heating of the crucible 3, substantially pure methane to feed at least one burner 10 to bring the desired temperature Ti of the crucible 3.

In accordance with an additional embodiment of the method, the additional step is provided of using, at steady state temperature, exhaust gas 9 flowed out of the crucible 3 and brought to ambient pressure Pe as fuel to feed at least one burner 10 and maintain the desired temperature Ti of the crucible 3.

In accordance with an additional embodiment of the method, the additional step is provided of adding fuel gas 13 to the exhaust gas 9 flowing out of the crucible 3.

In accordance with an additional embodiment of the method, the additional step is provided of placing the crucible 3 in a furnace for oxides 11.

For example, said furnaces are furnaces with oxidic refractories like aluminas and/or mullite in which cycles with oxidizing atmospheres are carried out. In these furnaces, Kanthal® or super Kanthal® electrical resistors are used. For example, a furnace of this type is the Nabertherm GmbH muffle furnace with maximum temperature of 1400°C and 400 liters of volume.

In accordance with an additional embodiment of the method, the additional step is provided of maintaining the inner chamber of the furnace 12 in oxidizing environment.

In accordance with an additional embodiment of the method, the additional step is provided of maintaining the inner chamber of the furnace 12 at the pressure that can reach ambient temperature Pe.

In accordance with an additional embodiment of the method, the additional step is provided of bringing the pressure of the pressure inside the furnace 12 to the pressure at 30 - 90 Kpa.

In accordance with an additional embodiment of the method, the additional step is provided of maintaining an ambient temperature Ta outside said furnace for oxides 11.

In accordance with an additional embodiment of the method, the additional step is provided of providing a crucible 3 of silicon carbide SiC.

In accordance with an additional embodiment of the method, the additional step is provided of providing a crucible 3 of silicon-infiltrated silicon carbide (Si-SiC).

In accordance with an additional embodiment of the method, the additional step is provided of providing a crucible (3) of silicon-infiltrated (Si-SiC) sintered silicon carbide (SiC).

In accordance with an additional embodiment of the method, the additional step is provided of providing a crucible 3 of boron carbide B4C.

In accordance with an additional embodiment of the method, the additional step is provided of providing a crucible 3 of silicon-infiltrated boron carbide (Si-B4C).

In accordance with an additional embodiment of the method, the additional step is provided of providing a crucible 3 of zirconium carbide ZrC.

In accordance with an additional embodiment of the method, the additional step is provided of providing a crucible 3 of silicon-infiltrated zirconium carbide (Si-ZrC).

In accordance with an additional embodiment of the method, the additional step is provided of providing a crucible 3 made of a combination of silicon carbide SiC, boron carbide B4C and zirconium carbide BZrC.

In accordance with an additional embodiment of the method, the additional step is provided of providing a crucible 3 of sintered silicon carbide SiC.

In accordance with one embodiment, the crucible is 100% of sintered SiC or silicon-infiltrated SiC, for example obtained from a preform of Si-infiltrated SiC powder. This material allows to work up to 1400°C, while being far easier and faster to produce than traditional crucibles.

This crucible has the desired conductivity in addition to the desired resistance to the oxidizing environment.

These crucibles withstand oxidation because they are passivated upon contact with oxygen, where part of the product is transformed into a micrometric film of SiO2 or oxidic glasses that protects the crucible itself.

In accordance with an additional embodiment of the method, the additional step is provided of providing a crucible 3 that comprises an open container 14 forming an inner loading chamber 15 for loading the porous components 1 to be densified.

In accordance with an additional embodiment of the method, the additional step is provided of providing an open container 14 that comprises container support surfaces 16 wherein said container support surfaces 16 are ground and lapped.

In accordance with an additional embodiment of the method, the additional step is provided of providing a crucible 3 that comprises a crucible lid 17 having lid support surfaces 18 for setting the lid 17 on the open container 14, wherein said lid support surfaces 18 are ground and lapped.

In accordance with an additional embodiment of the method, the additional step is provided of directly setting said lid support surfaces 18 on said container support surfaces 16 closing said crucible in a gas-tight manner; bringing the pressure of the closed inner loading chamber to a pressure between 0.1 kPa and 25 kPa.

In accordance with an additional embodiment of the method, the additional step is provided of maintaining a pressure differential between the inner chamber 15 of the crucible 3 and the chamber 12 of the furnace 11 of at least 5 kPa so that the inner chamber 15 is in a vacuum with respect to the outer chamber or chamber of the furnace 11.

In accordance with an additional embodiment of the method, the additional step is provided of maintaining a pressure differential between the inner chamber 15 of the crucible 3 and the chamber 12 of the furnace 11 of at least 10 kPa so that the inner chamber 15 is in a vacuum with respect to the outer chamber or chamber of the furnace 11.

In accordance with an additional embodiment of the method, the additional step is provided of setting said lid support surfaces 18 on said container support surfaces 16 closing said crucible in a gas-tight manner interposing a sealing gasket 19; bringing the pressure of the closed inner loading chamber to a pressure between 0.1 kPa and 25 kPa.

The present invention further relates to an assembly that allows to implement one of the methods described above.

In accordance with a general embodiment, an assembly 1 for densifying porous components, according to the methodology known as Chemical Vapor Infiltration, comprises:
- at least one crucible 3 able to receive porous components 1 to be densified;
- said crucible 3 is made of material capable of withstanding the densification temperature and pressure and capable of being internally exposed to reducing atmosphere;
- said crucible 3 comprises a crucible inlet 5 for injecting into the crucible 3 gas suitable for densification 4 at a predetermined pressure Pi and a predetermined flow rate Q;
- said crucible 3 comprises a crucible outlet 7 for the evacuation of the exhaust gas 10;
- said assembly 1 further comprises a furnace 12 able to operate internally at temperatures suitable for the CVI process.

In accordance with one embodiment, said crucible 3 is positioned inside said furnace 12; and wherein said assembly 1 further comprises a vacuum pump 22 able to create a pressure between 0.1 kPa inside said crucible 3;

In accordance with one embodiment, said crucible 3 is of a material able to be exposed externally to an oxidizing atmosphere; and wherein said crucible 3 is made of material having thermal conductivity above 30 W/mK from ambient temperature to 1000° C.

In accordance with a different general embodiment wholly independent of the preceding one, an assembly 1 for densifying porous components, according to the methodology known as Chemical Vapor Infiltration, comprising:
- at least one crucible 3 able to receive porous components 1 to be densified;
- said crucible 3 is made of graphite able to withstand the densification temperature and pressure;
- said crucible 3 comprises a crucible inlet 5 for injecting into the crucible 3 gas suitable for densification 4 at a predetermined pressure Pi and a predetermined flow rate Q;
- said crucible 3 comprises a crucible outlet 7 for the evacuation of the exhaust gas 10;
- said assembly 1 further comprises a furnace 12 able to operate internally at temperatures suitable for the CVI process.

Advantageously, said crucible 3 is positioned inside said furnace 12.

In accordance with one embodiment, said assembly 1 further comprises a vacuum pump 22 able to create a pressure between 0.1 kPa and 25 KPa inside said crucible.

In accordance with one embodiment, said crucible 3 is of a material able to be exposed externally to an oxidizing atmosphere.

In accordance with one embodiment, said furnace 12 delimits an internal chamber to the furnace 12 that laps said crucible 3 and placed at an atmospheric pressure of approximately 90KPa.

In accordance with one embodiment, said assembly 1 further comprises a vacuum pump 22 able to create a pressure between 0.1 KPa and 25 KPa inside said crucible so that, at steady state, a reducing environment is formed inside said crucible 3.

In accordance with one embodiment, said crucible 3 is able to be exposed externally to an atmospheric pressure of approximately 90 KPa.

In accordance with one embodiment, said open container 15 delimits an inner loading chamber 16 able to receive at least a disk braking rotor 1 of a disk brake to be densified, preferably a plurality of rotors 1 of disk for disk brake to be densified.

In accordance with one embodiment, said assembly 1 further comprises a furnace 12 of the type for oxides 12 able to operate internally at ambient pressure and temperatures suitable for the CVI process.

In accordance with one embodiment, said crucible 3 is of graphite.

In accordance with one embodiment, said crucible 3 is externally jacketed with oxide-resistant coating.

In accordance with one embodiment, said coating comprises engobbio ® or engobe.

In accordance with one embodiment, said chamber external to the crucible 12 or chamber internal to the furnace 12 is an oxidizing environment, wherein said external environment laps upon said crucible 3.

In accordance with one embodiment, said crucible 3 comprises an open container 15 and a lid 17 able to close said open container 15 in a gas-tight manner.

In accordance with one embodiment, said open container 15 delimits an inner loading chamber 16 able to receive at least one porous component 1, preferably a plurality of porous components 1.

In accordance with one embodiment, said open container 14 comprises container support surfaces 16 wherein said container support surfaces 16 are ground and lapped.

In accordance with one embodiment, said crucible lid 17 comprises lid support surfaces 18 for setting the lid 17 on the open container 14, wherein said lid support surfaces 18 are ground and lapped.

In accordance with one embodiment, said lid support surfaces 18, with the crucible 3 closed, are set on said container support surfaces 16 closing said crucible 3 in a gas-tight manner.

In accordance with one embodiment, said lid support surfaces 18, with the crucible 3 closed, are set on said container support surfaces 16 closing said crucible 19 in a gas-tight manner interposing a sealing gasket 19.

In accordance with one embodiment, said crucible 3 is of a material able to have externally an atmospheric pressure of approximately 90 KPa.

In accordance with one embodiment, said assembly 1 further comprises a furnace 12 of the type for oxides 12 able to operate internally at ambient pressure and temperatures suitable for the CVI process.

In accordance with one embodiment, said crucible 3 is externally jacketed with oxide-resistant coating.

In accordance with one embodiment, said outer coating of the crucible 3 comprises engobbio® or engobe.

In accordance with one embodiment, said coating is made of material comprising metals, for example refractory steels.

In accordance with one embodiment, the chamber external to the crucible 12 or chamber internal to the furnace 12 is an oxidizing environment, wherein said environment laps upon said crucible 3.

In accordance with one embodiment, said crucible comprises silicon carbide SiC.

In accordance with one embodiment, said crucible (3) comprises silicon-infiltrated silicon carbide (Si-SiC);
. and/or wherein
- said crucible (3) comprises silicon-infiltrated (Si-SiC) sintered silicon carbide (SiC);
   and/or wherein
- said crucible 3 comprises boron carbide B4C;
   and/or wherein
- said crucible (3) comprises silicon-infiltrated boron carbide (Si-B4C);
   and/or wherein
- said crucible 3 comprises zirconium carbide ZrC;
   and/or wherein
- said crucible (3) comprises silicon-infiltrated zirconium carbide (Si-ZrC);
   and/or wherein
- said crucible 3 comprises a combination of silicon carbide SiC, boron carbide B4C and zirconium carbide ZrC;
   and/or wherein
- said crucible 3 comprises sintered silicon carbide SiC.

In accordance with one embodiment, said open container 14 comprises silicon carbide SiC.

In accordance with one embodiment, said crucible lid 17 comprises silicon carbide SiC.

In accordance with one embodiment, said crucible inlet 5 is provided in said open container 14.

In accordance with one embodiment, said crucible outlet 6 is provided in said crucible lid 17.

In accordance with one embodiment, said vacuum pump 21 is a nitrogen backflow pump able to maintain said exhaust gases 9 dry. For example, said vacuum pump 21 is a screw pump NC 0100 B, NC 0200 B, NC 0300 B by Ateliers Busch S.A., or a cryogenic pump, for example a NIKKISO cryogenic pump by Lewa GmbH.

In accordance with one embodiment, said vacuum pump 21 is able to bring said exhaust gases 9 to an ambient pressure downstream of said vacuum pump 21, or a limited overpressure able to convey said exhaust gases 9 to at least one burner 10.

In accordance with one embodiment, downstream of said vacuum pump 21 is provided an accumulation tank 50 of the exhaust gas 9.

In accordance with one embodiment, said tank comprises a device for separating tar and/or cyclic aromatic hydrocarbons 40; and said assembly 1 comprises a cooling device 51 for cooling the exhaust gases 9.

In accordance with one embodiment, said furnace for oxides 11 comprises resistance heating components 22, 42.

In accordance with one embodiment, said furnace 11 comprises inductance heating components.

In accordance with one embodiment, said furnace for oxides 11 comprises free flame heating components, for example burners 10 able to operate at ambient pressure.

In accordance with one embodiment, said furnace for oxides 11 comprises four burners 10.

In accordance with one embodiment, said assembly 1 comprises a recirculation conduit 23 that fluidically connects said vacuum pump 21 with said at least one burner 10.

In accordance with one embodiment, said recirculation conduit 23 comprises an inlet of fuel gas 24 for the entry into said conduit of a fuel gas 13 to be added to a burner exhaust gas.

In accordance with one embodiment, said furnace for oxides 11 comprises a combustion fume exhaust conduit 38.

In accordance with one embodiment, said assembly 20 comprises at least one tank or a circuit 39 for supplying gas suitable for densification, for example methane CH4, connected to said crucible inlet 5.

In accordance with one embodiment, at least one tank or one circuit is provided for supplying technical service gas, for example nitrogen and/or argon or the like for washing the inner chamber of the crucible during the heating phases until the desired temperature of the crucible is reached.

In accordance with one embodiment, said assembly 20 comprises a device for separating tar and/or cyclic aromatic hydrocarbons 40 connected downstream of said crucible outlet 6.

In accordance with one embodiment, said assembly 20 comprises an exhaust gas conduit 41 connected downstream of said vacuum pump 21.

In accordance with one embodiment of the method, said gas suitable for densification 4 is methane gas, or butane, or ethane, or propane or a combination of at least two thereof.

In accordance with one embodiment, said assembly 1 comprises a carrousel device 25 that comprises a closed path continuous movement device 26 that supports at least two crucibles 3.

In accordance with one embodiment, a closed path continuous movement device 26 comprises a loading segment 27 suitable for loading at least one porous component 1 in said crucible 3 when open.

In accordance with one embodiment, a closed path continuous movement device 26 comprises an unloading segment 28 suitable for unloading at least one densified component 2 from said crucible 3 when open.

In accordance with one embodiment, a closed path continuous movement device 26 comprises a treatment segment 29 associated with a continuous furnace 30 of the continuous furnace for oxides type, for example a tunnel kiln by Riedhammer.

In accordance with one embodiment, said continuous furnace 30 allows the entry of the at least two crucibles 3 and their exit.

In accordance with one embodiment, said carrousel device 25 comprises a movable feeding device 31 connected removably to at least one of the at least two crucibles 3 for feeding said densifying gas 4; and said carrousel device 25 comprises a movable evacuation device 32 for evacuating the exhaust gas 9 from at least one crucible 3 and placing the crucible 3 in a vacuum bringing the pressure of the crucible between 1 KPa and 15 KPa.

In accordance with one embodiment, said crucible inlet 5 comprises a quick-fitting crucible inlet valve 33 for selectively connecting and disconnecting said movable feeding device 31 for feeding the densifying gas 4; and said crucible outlet 6 comprises a quick-fitting crucible outlet valve 34 for selectively connecting and disconnecting said movable evacuation device 32 for the evacuation of said exhaust gas 9 and creating vacuum in the crucible 3.

In accordance with one embodiment, said closed path continuous movement device 26 comprises a porous component loading station 35 for loading at least one porous component 1 in said crucible 3.

In accordance with one embodiment, said closed path continuous movement device 26 comprises a densified component unloading station 36 for unloading at least one densified component 2 from said crucible 3.

In accordance with an additional embodiment, a system, for example a system useful for testing, comprises a crucible or reactor chamber of silicon carbide or SiC. The material used is silicon-infiltrated silicon carbide. The chamber consists of two parts, the main container and the lid. The structure is cylindrical with dimensions of the part useful for loading the preforms of 400 mm in diameter and 335 mm in height. The thickness of the walls is 8 mm. The two parts are in contact through a lapped flange on a surface of 700 cm2 that allows to obtain the vacuum tightness. The chamber was constructed according to our design.

The furnace, of a commercial type (for example for oxides), consists of a simple pit furnace that can work at a maximum temperature of 1320°C, has Kanthal® resistors and an electric power of 13.2 kW. The insulation is of alumina-based oxide refractory.

The cooling line is made of stainless steel within inner diameter 100 mm, jacketed and water-cooled. It is formed by 3 inclined segments for a total extension of approximately 10 meters. Along the line are inserted two pits for collecting the condensed hydrocarbons.

The pumping group is formed by a double screw dry pump with maximum flow rate of 150 m3/h and maximum vacuum level of 0.5 mbar.

. The specific construction of the system used for testing had the main purpose of demonstrating the validity of the innovative concepts introduced and in the second place to have available the information necessary to design a more efficient and functional system.

Summary of the experimental tests. The first part of the experimentation pertained to the verification of the design specifications of the system, in particular of:
- maximum operating temperature,
- heating and heat dissipation gradients,
- minimum vacuum level and leakage,
- control of process gas flows,
- flows of the cooling water of the vacuum line.

This phase allowed above all to optimize the vacuum tightness systems.

Subsequently, the densification tests were started in order to identify the process parameters that would allow to maximize carbon deposition efficiency. The relevant parameters are the temperature in the holding phase of the process, the flow of methane, the level of partial pressure, the duration of the process, the geometry of the load. The ranges of the aforesaid variables that were explored are as follows:
- maximum holding temperature: 1040-1140°C;
- flow of methane: 15-60 nl/min;
- partial pressure: 75-220 mbar

The composition of methane that was maintained constant (Siad 98%)

Initially, carbonized felt was used as the starting material. The felt, in the form of a roll with a height of 300 mm, was wound to form a cylinder of such diameter as to occupy the entire useful space of the reaction chamber. The flow of the gas then took place entirely through the mass of the material to be densified. Following 5 test cycles, after identifying the best process conditions a maximum weight increase by 17.5% in one hour and by 34.5% in two hours was obtained. The deposit was morphologically uneven and the fibers did not appear to be homogeneously coated by the CVI carbon.

Thereupon, maintaining the same geometry, graphitized felt was used, with which in general a significant increase in deposition efficiency was obtained. Regulating the process parameters, a weight increase of 24.6% in one hour and of 92.6% in 4 hours was attained. With this type of preform, the CVI carbon was homogeneous in thickness from the first deposit layers.

Then for the tests carried out it seems possible to densify without particular additional devices and with the same efficiency as traditional CVI furnaces:
- preforms with different geometry;
- different load configurations;
- preforms with different density.

### LIST OF REFERENCES

- 1: porous component
- 2: densified component
- 3: crucible
- 4: gas suitable for densification
- 5: crucible inlet
- 6: crucible outlet
- 7: fumes flowing out of the crucible
- 8: tar and/or cyclic aromatic hydrocarbons
- 9: exhaust fumes flowing out of the crucible
- 10: at least one burner
- 11: furnace for oxides
- 12: inner chamber of furnace for oxides
- 13: fuel gas to be added to exhaust gas for burner
- 14: open container
- 15: inner loading chamber
- 16: container support surfaces
- 17: crucible lid
- 18: lid support surfaces
- 19: crucible sealing gasket
- 20: assembly
- 21: vacuum pump
- 22: resistance heating elements
- 23: recirculation conduit
- 24: fuel gas inlet
- 25: carrousel device
- 26: closed path continuous movement device
- 27: loading segment
- 28: unloading segment
- 29: treatment segment
- 30: continuous furnace - we reference Riedhammer SACMI sanitaryware kiln carriage tunnel furnace
- 31: movable feeding device
- 32: movable evacuating device
- 33: quick-fitting crucible inlet valve
- 34: quick-fitting crucible outlet valve
- 35: porous component loading station
- 36: densified component unloading station
- 37: flow meter
- 38: combustion fume exhaust conduit
- 39: tank for gas suitable for densification for example CH4 or circuit
- 40: tar and/or cyclic aromatic hydrocarbon separation device
- 41: exhaust fume exhaust conduit
- 42: resistor heating elements for example made of Kanthal or super-Kanthal
- 50: exhaust gas accumulation tank
- 51: exhaust gas cooling device
- 52: vacuum pump for environment outside the crucible and inside the furnace
- Pi: pressure inside the crucible
- Ti: temperature inside the crucible
- Ta: Ambient temperature
- Pe: pressure external to the crucible
- Q: pre-set flow rate of densifying gas

## Claims

1. CVI (chemical vapor infiltration) method for densifying at least one porous component (1), comprising at least the steps of:
- placing the at least one porous component (1) inside a crucible (3);
- bringing the temperature (Ti) and the pressure (Pi) inside the crucible (3) to a suitable value for the densification of the porous component (1) to transform it into a densified or partially densified component (2);
- upon reaching steady state temperature and pressure, flushing a reaction gas (4) suitable for the densification of the porous component (1) to transform it into a densified component (2) inside the crucible (3);
**characterized in that** it comprises the additional steps of
- maintaining an oxidizing environment external to the crucible (3), wherein said external environment laps upon said crucible (3);
and wherein
- said crucible (3) is provided in a material that allows a thermal conductivity above 30 W/mk from ambient temperature to at least 1000°C.

2. A method according to claim 1, comprising the additional steps of:
- at steady state temperature and pressure and gas flushing, obtaining a non-oxidizing or reducing environment inside the crucible (3);
and/or wherein
- maintaining the temperature (Ti) and the pressure (Pi) inside the crucible (3) at a suitable value for the densification of the porous component (1) to transform it into a densified or partially densified component (2);
and/or wherein
- bringing the temperature (Ti) inside the crucible (3) between 900°C and 1300°C, preferably from 1050 to 1200°C;
and/or comprising the additional steps of:
- bringing the pressure (Pi) inside the crucible (3) between 0.1 and 25 KPa, preferably between 1-20 KPa;
and/or comprising the additional steps of:
- regulating the flow of the gas (4) at the inlet (5) of the crucible (3) in a value between 0.1 l/min/dm3 and 10 l/min/dm3 preferably in a value between 1 l/min/dm3 and 5 l/min/dm3, where dm3 are understood as the volume of the chamber of the crucible;
and/or comprising the additional steps of:
- upon reaching steady state temperature suitable for densification, obtaining a non-oxidizing or reducing environment inside the crucible (3); and wherein, during the entire process, an oxidizing environment is maintained outside the crucible (3), wherein said external environment laps said crucible (3);
and/or comprising the additional steps of:
- the pressure (Pe) external to the crucible (3) is maintained at ambient pressure (approximately 90 KPa) and otherwise at over-pressure with respect to the pressure (Pi) of the crucible (3);
and/or comprising the additional steps of:
- said crucible (3) is made of a material that allows a thermal conductivity between 120 and 80 W/mK at 400°C;
and/or comprising the additional steps of:
- providing as the porous component (1) a component with matrix comprising fibers;
and/or comprising the additional steps of:
- providing as the porous component (1) a component with matrix comprising carbon fibers;
and/or comprising the additional steps of:
- providing as the porous component (1) a component with matrix comprising silicon carbon (SiC) fibers;
and/or comprising the additional steps of:
- jacketing said crucible (3) with oxidation-resistant coating;
and/or wherein
- said coating is made of material comprising engobbio ®, or engobe,
and/or wherein
- said coating is made of a material comprising metals, for example refractory steels.

3. A method, according to any of the preceding claims, comprising the additional steps of:
- during the start of the process, until the temperature of the crucible reaches a value close to the suitable value for the densification of the porous component (1) to transform it into a densified component (2), washing the crucible with nitrogen (N2):
and/or comprising the additional steps of:
- bringing the pressure (Pi) inside the crucible (3) between 1 and 20 KPa, preferably between 10 and 15 KPa;
and/or comprising the additional steps of:
- said crucible (3) avoids defining a thermal barrier between the environment outside the crucible and the environment inside the crucible;
and/or comprising the additional steps of:
- the pressure (Pe) external to the crucible (3) is maintained at ambient pressure;
and/or comprising the additional steps of:
- regulating the flow of the gas (4) at the inlet (5) of the crucible (3) between 10 I/min and 60 I/min;
and/or comprising the additional steps of:
- bringing the pressure (Pe) outside the crucible (3) to no less than 15 KPa.
and/or wherein
- maintaining a pressure difference between the environment inside the crucible (3) and outside the crucible (3), wherein the external environment has an overpressure with respect to the internal environment above 5 KPa, preferably 10 KPa;

4. A method, according to any of the preceding claims, comprising the additional steps of:
- at the outlet (6) of the crucible (3), separating the tar and/or cyclic aromatic hydrocarbons (9) from the fumes (7) flowing out of the crucible.

5. A method, according to any of the preceding claims, comprising the additional steps of:
- feeding to the crucible (3) as gas suitable for densification (4) methane, or butane, or ethane, or propane, or a combination thereof, and/or preferably methane with purity of 96%.

6. A method, according to any of the preceding claims, comprising the additional steps of:
- bringing the exhaust gas (9) flowed out of the crucible (3) to ambient temperature (Pe);
and/or comprising the additional steps of:
- accumulating the exhaust gas (9) at ambient temperature in an accumulation tank (50).

7. A method, according to any of the preceding claims, comprising the additional steps of:
- using exhaust gas (9) flowed out of the crucible (3) and brought to ambient pressure (Pe) as fuel for feeding at least one burner (10) to bring and/or maintain the desired temperature (Ti) of the crucible (3);
and/or comprising the additional steps of:
- during the initial heating of the crucible (3), using methane to feed at least one burner (10) to bring the desired temperature (Ti) of the crucible (3);
then at steady state
- using exhaust gas (9) flowed out of the crucible (3) and brought to ambient pressure (Pe) as fuel for feeding at least one burner (10) and maintain the desired temperature (Ti) of the crucible (3);
and/or comprising the additional steps of:
- adding fuel gas (13) and comburent air to the exhaust gas (9) flowing out of the crucible (3).

8. A method, according to any of the preceding claims, comprising the additional steps of:
- placing the crucible (3) in a furnace for oxides (11);
and/or comprising the additional steps of:
- maintaining the inner chamber of the furnace (12) in oxidizing environment
and/or comprising the additional steps of:
- maintaining the inner chamber of the furnace (12) at the pressure that can reach ambient temperature (Pe);
and/or comprising the additional steps of:
- bringing the pressure of the inner chamber of the furnace (12) to a pressure between 15 KPa and 90 KPa;
and/or comprising the additional steps of:
- maintaining an ambient temperature (Ta) outside said furnace for oxides (11).

9. A method, according to any of the preceding claims, comprising the additional steps of:
- providing a crucible (3) of sintered silicon carbide (SiC);
and/or comprising the additional steps of:
- providing a crucible (3) of silicon-infiltrated silicon carbide (Si-SiC);
and/or comprising the additional steps of:
- providing a crucible (3) of sintered boron carbide (B4C);
and/or comprising the additional steps of:
- providing a crucible (3) of silicon-infiltrated boron carbide (Si-B4C);
and/or comprising the additional steps of:
- providing a crucible (3) of sintered zirconium carbide (ZrC);
and/or comprising the additional steps of:
- providing a crucible (3) of silicon-infiltrated zirconium carbide (Si-ZrC);
and/or comprising the additional steps of:
- providing a crucible (3) of a combination of silicon carbide (SiC), boron carbide (B4C) and zirconium carbide (ZrC), sintered and/or silicon infiltrated;

10. A method, according to any of the preceding claims, comprising the additional steps of:
- providing a crucible (3) that comprises an open container (14) forming an inner loading chamber (15) for loading the porous components (1) to be densified;
- providing said open container (14) which comprises container support surfaces (16) wherein said container support surfaces (16) are ground and lapped;
- providing a crucible (3) that comprises a crucible lid (17) having lid support surfaces (18) for setting the lid (17) on the open container (14), wherein said lid support surfaces (18) are ground and lapped;
and/or wherein
- directly setting said lid support surfaces (18) to said container support surfaces (16) closing said crucible in a gas-tight manner;
- bringing the pressure of the inner chamber to a pressure between 0.1 KPa and 25 KPa;
and/or wherein
- maintaining a pressure differential between the inner chamber (15) of the crucible (3) and the chamber (12) of the furnace (11) of at least 5 KPa preferably 10 KPa so that the inner chamber (15) is in a vacuum with respect to the outer chamber or chamber of the furnace (11);
and/or wherein
- directly setting said lid support surfaces (18) to said container support surfaces (16) closing said crucible in a gas-tight manner interposing a sealing gasket (19);
- bringing the pressure of the inner chamber to a pressure between 0.1 KPa and 25 KPa.

11. An assembly (1) for densifying porous components, according to the methodology known as Chemical Vapor Infiltration, comprising:
- at least one crucible (3) able to receive porous components (1) to be densified;
- said crucible (3) being made of material capable of withstanding the densification temperature and pressure and capable of being internally exposed to reducing atmosphere, or process temperature and pressure;
- said crucible (3) comprises a crucible inlet (5) for injecting into the crucible (3) gas suitable for densification (4) at a predetermined pressure (Pi) and a predetermined flow rate (Q);
- said crucible (3) comprises a crucible outlet (6) for the evacuation of the exhaust gas (10);
- said assembly (1) further comprises a furnace (12) able to operate internally at temperatures suitable for the CVI process;
- said crucible (3) is positioned inside said furnace (12); and wherein
- said assembly (1) further comprises a vacuum pump (22) able to create the process pressure inside said crucible; **characterized in that**
- said crucible (3) is of a material able to be exposed externally to an oxidizing atmosphere;
and wherein
- said crucible (3) is made of a material having thermal conductivity above 30 W/mK from ambient temperature to 1000°C.

12. An assembly (1) according to claim 11, wherein
- said assembly (1) further comprises a vacuum pump (22) able to create a pressure between 0.1 kPa and 25 KPa inside said crucible;
- said crucible (3) comprises an open container (14) and a lid (17) able to close said open container (14) in a gas-tight manner;
and/or wherein
- said open container (14) delimits an inner loading chamber (15) able to receive at least one porous component (1), preferably a plurality of porous components (1);
- said open container (14) delimits an inner loading chamber (15) able to receive at least a disk braking rotor (1) of a disk brake to be densified, preferably a plurality of disk rotors (1) for disk brake to be densified;
and/or wherein
- said open container (14) comprises container support surfaces (16) wherein said container support surfaces (16) are ground and lapped;
and/or wherein
- said crucible lid (17) comprises lid support surfaces (18) for setting the lid (17) on the open container (14), and wherein said lid support surfaces (18) are ground and lapped;
and/or wherein
- said lid support surfaces (18), with the crucible (3) closed, are set on said container support surfaces (16) closing said crucible (3) in a gas-tight manner;
and/or wherein
- said lid support surfaces (18), with the crucible closed, are set on said container support surfaces (16) closing said crucible in a gas-tight manner interposing a sealing gasket (19);
and/or wherein
- said crucible (3) is of a material able to have externally an atmospheric pressure of (approximately 90 KPa);
and/or wherein
- said assembly (1) further comprises a furnace of the type for oxides (12) able to operate internally at ambient pressure and temperatures compatible and suitable for the CVI process;
and/or wherein
- said crucible (3) is externally jacketed with oxide-resistant coating;
and/or wherein
- said outer coating of the crucible 3 comprises engobbio® or engobe;
and/or wherein
- said coating is made of a material comprising metals, for example refractory steels.
and/or wherein
- the chamber external to the crucible (12) or chamber internal to the furnace (12) is an oxidizing environment, wherein said chamber (12) or said environment laps upon said crucible (3).

13. An assembly (1) according to claim 11 and/or 12, wherein
- said crucible comprises silicon carbide (SiC);
and/or wherein
- said crucible (3) comprises sintered silicon carbide (SiC);
and/or wherein
- said crucible (3) comprises silicon-infiltrated silicon carbide (Si-SiC);
and/or wherein
- said crucible (3) comprises sintered boron carbide (B4C);
and/or wherein
- said crucible (3) comprises silicon-infiltrated boron carbide (Si-B4C);
and/or wherein
- said crucible (3) comprises sintered zirconium carbide ZrC;
and/or wherein
- said crucible (3) comprises silicon-infiltrated zirconium carbide (Si-ZrC);
and/or wherein
- said crucible (3) comprises a combination of silicon carbide (SiC), boron carbide (B4C) and zirconium carbide (ZrC), sintered and/or silicon-infiltrated;
and/or wherein
- said open container (14) is of silicon carbide (SiC);
and/or wherein
- said crucible lid (17) is of silicon carbide (SiC);
and/or wherein
- said crucible inlet (5) is provided in said open container (14);
and/or wherein
- said crucible outlet (6) is provided in said crucible lid (17).

14. An assembly (1) according to any of the claims from 11 to 13, wherein
- said vacuum pump (21) is a nitrogen backflow pump able to maintain said exhaust gases (9) dry;
and/or wherein
- said vacuum pump (21) is able to bring said exhaust gases (9) to an ambient pressure downstream of said vacuum pump (21), or a limited overpressure able to convey said exhaust gases (9) to at least one burner (10);
and/or wherein
- downstream of said vacuum pump (21) is provided an accumulation tank (50) of the exhaust gas (9);
and/or wherein
- said tank comprises a tar and/or cyclic aromatic hydrocarbon separation device (40);
- said assembly (1) comprises a cooling device (51) for cooling the exhaust gases (9).

15. An assembly (1) according to any of the claims from 11 to 14, wherein
- said furnace for oxides (11) comprises resistance heating components (22, 42);
and/or wherein
- said furnace (11) comprises inductance heating components;
and/or wherein
- said furnace for oxides (11) comprises free flame heating components, for example burners (10) able to operate at ambient pressure;
and/or wherein
- said assembly (1) comprises a recirculation conduit (23) that fluidically connects said vacuum pump (21) with said at least one burner (10);
and/or wherein
- said recirculation conduit (23) comprises an inlet of fuel gas (24) for the entry into said conduit of a fuel gas (13) to be added to a burner exhaust gas;
and/or wherein
- said furnace for oxides (11) comprises a combustion fume exhaust conduit (38);
and/or wherein
- said assembly (20) comprises at least one tank or a circuit (39) for supplying gas suitable for densification, for example methane (CH4), connected to said crucible inlet (5);
and/or wherein
- said assembly (20) comprises a device for separating tar and/or cyclic aromatic hydrocarbons (40) connected downstream of said crucible outlet (6);
and/or wherein
- said assembly (20) comprises an exhaust gas conduit (41) connected downstream of said vacuum pump (21);
and/or wherein
- said gas suitable for densification (4) is methane gas, or butane, or ethane, or propane or a combination of at least two thereof;
and/or wherein
- said assembly (1) comprises a carrousel device (25) that comprises a closed path continuous movement device (26) that supports at least two crucibles (3);
and/or wherein
- said closed path continuous movement device (26) comprises a loading segment (27) suitable for loading at least one porous component (1) in said crucible (3) when open;
and/or wherein
- said closed path continuous movement device (26) comprises an unloading segment (28) suitable for unloading at least one densified component (2) from said crucible (3) when open;
and/or wherein
- said closed path continuous movement device (26) comprises a treatment segment (29) associated with a continuous furnace (30) of the continuous furnace for oxides type;
and/or wherein
- said continuous furnace (30) allows the entry of the at least two crucibles (3) and their exit;
and/or wherein
- said carrousel device (25) comprises a movable feeding device (31) connected removably to at least one of the at least two crucibles (3) for feeding said densifying gas (4);
- said carrousel device (25) comprises a movable evacuation device (32) for evacuating the exhaust gas (9) from at least one crucible (3) and placing the crucible (3) in a vacuum bringing the pressure of the crucible between 0.1 KPa and 25 KPa; and/or wherein
- said crucible inlet (5) comprises a quick-fitting crucible inlet valve (33) for selectively connecting and disconnecting said movable feeding device (31) for feeding the densifying gas (4);
- said crucible outlet (6) comprises a quick-fitting crucible outlet valve (34) for selectively connecting and disconnecting said movable evacuation device (32) for the evacuation of said exhaust gas (9) and creating vacuum in the crucible (3);
and/or wherein
- said closed path continuous movement device (26) comprises a porous component loading station (35) for loading at least one porous component (1) in said crucible (3);
and/or wherein
- said closed path continuous movement device (26) comprises a densified component unloading station (36) for unloading at least one densified component (2) from said crucible (3).
